Europäisches Patentamt

European Patent Office

Office européen des brevets

(11) Veröffentlichungsnummer: **0 472 055 A1**

# (12) EUROPÄISCHE PATENTANMELDUNG

(21) Anmeldenummer: **91113279.3**

(22) Anmeldetag: **07.08.91**

(51) Int. Cl.5: **H01L 21/314**, H01L 29/40

(30) Priorität: **20.08.90 DE 4026314**

(43) Veröffentlichungstag der Anmeldung:
**26.02.92 Patentblatt 92/09**

(84) Benannte Vertragsstaaten:
**DE FR GB IT NL SE**

(71) Anmelder: **SIEMENS AKTIENGESELLSCHAFT**
**Wittelsbacherplatz 2**
**W-8000 München 2(DE)**

(72) Erfinder: **Birkle, Siegfried, Dr.**
**Veit-Stoss-Strasse 46**
**W-8552 Höchstadt(DE)**
Erfinder: **Kammermaier, Johann, Dr.**
**Ziehrerstrasse 19**
**W-8025 Unterhaching(DE)**

(54) **MISFET.**

(57) Bei einem MISFET mit einer zwischen einer Gateelektrode und einem Halbleitersubstrat angeordneten Isolationsschicht ist die Isolationsschicht eine Schicht aus amorphem wasserstoffhaltigem Kohlenstoff (a-C:H) mit einer Dicke - im Bereich der Gateelektrode - bis zu 1 $\mu$m, die an der Grenzfläche zum Halbleitersubstrat einen spezifischen elektrischen Widerstand $\geq 10^6\,\Omega$.cm besitzt; das Halbleitersubstrat besteht aus einem Halbleitermaterial außer Silicium.

EP 0 472 055 A1

Die Erfindung betrifft einen MISFET mit einer zwischen einer Gateelektrode und einem Halbleitersubstrat angeordneten Isolationsschicht.

Wenn zwei Schichten mit verschiedenen elektrischen und chemischen Eigenschaften aneinandergrenzen, entstehen im allgemeinen sogenannte Heterostrukturen mit grundlegend neuen elektrischen Kenndaten, die technologisch steuerbar sind (siehe dazu: "J. Appl. Phys.", Vol. 62 (1987), Seiten 3799 bis 3802, und "Appl. Phys.", Vol. A 48 (1989), Seiten 549 bis 558). Eine entscheidende und wichtige Rolle spielen Heterostrukturen in FETs (FET = Field-Effect Transistor bzw. Feldeffekttransistor), die überwiegend mit Silicium (Si) in einer hochentwickelten Prozeßtechnik ausgeführt werden. Die Anwendung des FET-Prinzips auf andere Halbleitermaterialien, wie Ge, GaAs, GaP und InP, mit zum Teil besseren elektronischen Eigenschaften ist derzeit stark eingeschränkt. Dies ist darin begründet, daß sich eine geeignete Isolationsschicht zur Einbindung der Gateelektrode nicht - wie bei der MOS-Technik (MOS = Metal Oxide Semiconductor) - frei von Grenzflächenladungen in Form eines Oxids des Halbleitermaterials ("gate oxide") realisieren läßt und daß auch andere Isolationsschichten, beispielsweise aus Kunststoff, wie dies bei MISFETs (MIS = Metal Insulator Semiconductor) der Fall ist, mit der Halbleiteroberfläche nicht frei von Grenzflächenladungen verbunden werden können.

Zur Realisierung von Feldeffekttransistoren mit Halbleitermaterialien außer Silicium werden statt des MISFET-Prinzips bevorzugt das MESFET-Prinzip (MES = Metal Semiconductor) und das JFET-Prinzip (JFET = Junction-FET) angewendet (siehe dazu beispielsweise W. Kellner, H. Kniepkamp "GaAs-Feldeffekttransistoren", 2. Auflage (1989), Springer-Verlag, Seiten 19 bis 29 und 55). Diese Prinzipien beruhen auf der Nutzung der zwischen der Gateelektrode und dem Halbleitermaterial entstehenden SchottkyBarriere bzw. der Potentialbarriere eines pn-Übergangs. Mit derartigen Systemen können zwar hohe Schaltfrequenzen erreicht werden, im allgemeinen jedoch nur mit relativ hohen Leckströmen. Als grundsätzlicher Nachteil kommt noch eine vergleichsweise niedrige Sperrspannung hinzu, welche die Betriebsspannung für das System stark beeinträchtigt.

An Isolationsschichten in MISFETs, insbesondere auf der Basis von GaAs und InP, werden im allgemeinen folgende Anforderungen gestellt:

- Abscheidung in einem Niedertemperaturprozeß, um eine stoffliche Schädigung des Halbleitermaterials bzw. eine Abspaltung bestimmter Komponenten, beispielsweise As bei GaAs, zu vermeiden;
- stabile Haftung auf der Halbleiteroberfläche;
- Absättigung eventuell vorhandener freier Valenzen in der Halbleiteroberfläche (sogenannte "dangling bonds"), um Oberflächendefekte bzw. Rekombinationszentren zu beseitigen;
- Ausbildung gut umladbarer Heterostrukturen mit dem Halbleiter;
- niedrige Leckströme bzw. keine pin-holes.

Aufgabe der Erfindung ist es, einen MISFET (Metal Insulator Semiconductor Field-Effect Transistor) der eingangs genannten Art in der Weise auszugestalten, daß er eine defektarme Grenzfläche zwischen Isolator und Halbleiter aufweist.

Dies wird erfindungsgemäß dadurch erreicht, daß die Isolationsschicht eine Schicht aus amorphem wasserstoffhaltigem Kohlenstoff (a-C:H) mit einer Dicke - im Bereich der Gateelektrode - bis zu 1 $\mu$m ist, die an der Grenzfläche zum Halbleitersubstrat einen spezifischen elektrischen Widerstand $\geq 10^6 \, \Omega.$cm besitzt, und daß das Halbleitersubstrat aus einem Halbleitermaterial außer Silicium besteht.

Zur Realisierung von MISFETs nach der Erfindung dienen somit a-C:H/Halbleiter-Heterostrukturen; diese Heterostrukturen weisen eine stabile, rekombinationsarme Grenzfläche auf.

Amorpher wasserstoffhaltiger Kohlenstoff, kurz a-C:H, ist ein Kohlenstoffmaterial, bei dem ein amorphes Kohlenstoffnetzwerk vorliegt. Diese Modifikation von Kohlenstoff erhält ihre besonderen Eigenschaften, wie chemische Resistenz und elektrische Isolation, durch das Nebeneinander von tetraedrischer ($sp^3$) und trigonaler ($sp^2$) Hybridisierung; die amorphe Struktur wird durch den Einbau von Wasserstoff (etwa 10 bis 40 Atom-%) stabilisiert. Schichten aus amorphem wasserstoffhaltigem Kohlenstoff sind elektrisch isolierend. Der spezifische elektrische Widerstand dieses Materials kann nämlich bis über $10^{13} \Omega.$cm eingestellt werden.

Die MISFETs nach der Erfindung weisen eine a-C:H-Schicht mit einem spezifischen elektrischen Widerstand $\geq 10^6 \, \Omega.$cm an der Grenzfläche zum Halbleitersubstrat auf; vorzugsweise beträgt der spezifische elektrische Widerstand der Grenzfläche $\leq 10^9 \, \Omega.$cm. Der Gesamtwiderstand der Isolationsschicht aus a-C:H ist dabei wenigstens so groß wie der Widerstand der Grenzfläche. Die Grenzfläche besitzt im übrigen vorteilhaft eine Dicke bis zu 50 nm.

MISFETs nach der Erfindung weisen vorzugsweise Halbleitersubstrate aus Materialien mit hoher Ladungsträgerbeweglichkeit auf; dies sind insbesondere Ge, AIP, GaAs, GaP, GaSb, InAs, InP und InSb. Daneben kommen beispielsweise aber auch Materialien wie BN und SiC in Betracht. Vorteilhaft besteht das Halbleitersubstrat aus monokristallinem Material.

Zur Herstellung von MISFETs nach der Erfindung bzw. von a-C:H/Halbleiter-Heterostrukturen wird auf ein Halbleitersubstrat aus monokristallinem Material (Wafer) oder auf eine polykristalline oder amorphe Dünnschicht des Halbleitermaterials, die jeweils mit Source und Drain versehen sind, eine a-C:H-Schicht mit einer Dicke bis zu 1 μm aufgebracht; diese Isolationsschicht deckt in üblicher Weise den zwischen Source und Drain befindlichen Bereich des Halbleitersubstrats ab. Die a-C:H-Abscheidung erfolgt durch eine Hochfrequenz-Niederdruck-Plasmaabscheidung gasförmiger Kohlenwasserstoffe, gegebenenfalls in Gegenwart von Wasserstoff. Dabei lassen sich die Eigenschaften von a-C:H, wie der spezifische elektrische Widerstand und die Defektdichte, durch die Plasmabedingungen in einem relativ weiten Bereich steuern.

Die Herstellung der Isolationsschicht erfolgt vorteilhaft in der Weise, daß zunächst - unter Ausschluß von Luft - eine a-C:H-Schicht mit einer Dicke etwa bis zu 50 nm abgeschieden wird, die einen spezifischen elektrischen Widerstand bis zu $10^9\,\Omega.cm$ und einen optischen Bandabstand bis zu 1,1 eV aufweist; eine derartige Schicht ergibt eine ladungsfreie Grenzfläche. Auf diese Schicht wird dann im gleichen Plasmaprozeß - unter veränderten Plasmabedingungen (erhöhter Druck und/oder erniedrigte Leistungsdichte) - eine a-C:H-Schicht mit einem höheren spezifischen elektrischen Widerstand abgeschieden, d.h. mit einem Widerstand $> 10^9\,\Omega.cm$. Die Dicke dieser Schicht beträgt annähernd bis zu 1 μm. Dabei kann die Zunahme des Widerstandes sprunghaft oder kontinuierlich erfolgen.

Für die Abscheidung der a-C:H-Schichten gelten vorzugsweise folgende Bedingungen:
a) Schichten mit einem Widerstand $\leq 10^9\,\Omega.cm$:
- Druck: $\leq$ 50 Pa
- Leistungsdichte: $\leq$ 5 W.cm$^{-2}$
- DC-self-bias-Spannung: < -800 V;
b) Schichten mit einem Widerstand $> 10^9\,\Omega.cm$:
- Druck: bis zu 200 Pa
- Leistungsdichte: bis zu 0,5 W.cm$^{-2}$
- DC-self-bias-Spannung: > -400 V.

Um im Bereich von Source und Drain eine gute Kontaktierbarkeit mit Metall, beispielsweise Aluminium, zu gewährleisten, wird die a-C:H-Schicht strukturiert abgeschieden, d. h. lediglich im Bereich des Gatekanals. Im übrigen kann das Halbleitersubstrat im Bereich außerhalb von Source und Drain, d. h. in den von der Isolationsschicht entfernt liegenden Bereichen, vorteilhaft jeweils durch eine a-C:H-Schicht abgedeckt sein. Ferner kann die a-C:H-Schicht, falls erforderlich, im Bereich der Gateelektrode dünner ausgestaltet sein als in den an Source bzw. Drain grenzenden Bereichen; dies kann beispielsweise durch Abdecken oder nachträgliches Abätzen in einem Plasmaprozeß erfolgen. Ein Abfließen der Ladungen an der Gateelektrode wird durch den hohen Isolationswiderstand von a-C:H verhindert.

Für die Erzielung einer stabilen dünnen Barriereschicht aus a-C:H mit wenigen elektrisch aktiven Defekten in der Grenzfläche zum Halbleitersubstrat (im Überdeckungsbereich der Gateelektrode) ist von entscheidendem Vorteil, daß - aufgrund des nicht-thermischen Charakters der a-C:H-Abscheidung - in der Grenzfläche Bindungsverhältnisse erzielt werden können, die mit thermischen Prozessen, wie CVD (Chemical Vapour Deposition), nicht realisierbar sind. Dies trägt dazu bei, daß in der dünnen a-C:H-Schicht und in der Grenzfläche zum Halbleitersubstrat - aufgrund einer niedrigen Zustandsdichte - Verluste von Ladungsträgern durch Rekombination gering bleiben. In dieser Hinsicht besteht eine vorteilhafte Ausgestaltung des Verfahrens zur Herstellung der a-C:H/Halbleiter-Heterostruktur auch darin, daß die Halbleiteroberfläche - vor der a-C:H-Abscheidung - einer Plasmavorbehandlung, beispielsweise mit Argon oder Wasserstoff, unterworfen wird; auf diese Weise werden störende Fremdbestandteile, insbesondere Oxide, beseitigt. Bei einem derartigen Vorgehen eventuell entstehende freie Valenzen werden durch die nachfolgend abgeschiedene a-C:H-Schicht abgesättigt, wenn die Halbleiteroberfläche von Luft freigehalten wird.

Mit MISFETs, die erfindungsgemäß a-C:H/Halbleiter-Heterostrukturen aufweisen, lassen sich - bezüglich Gatespannungshöhe und Leckrate - Systeme realisieren, die mit nach MOS-Techniken hergestellten Systemen gleichwertig, und MESFET- bzw. JFET-Systemen überlegen sind. Darüber hinaus ist der technologische Aufwand bei den MISFETs geringer als bei bekannten MOS-FETs.

Anhand eines Ausführungsbeispiels soll die Erfindung noch näher erläutert werden.

Auf ein p-dotiertes Substrat aus monokristallinem GaAs mit einer Ladungsträgerkonzentration von annähernd $10^{18}$ cm$^{-3}$, das einer Vorbehandlung in einem Argon- oder Wasserstoffplasma (unter den nachfolgend beschriebenen Bedingungen bezüglich Druck und Leistung) unterzogen wurde, wird eine 0,1 μm dicke a-C:H-Schicht abgeschieden. Die Plasmaabscheidung erfolgt mit RF-Anregung (RF = Radiofrequenz) und einer sich infolge einer kapazitiven Energieeinkopplung ausbildenden DC-self-bias-Spannung; als Prozeßgas dient Methan, der Arbeitsdruck beträgt 20 Pa. Bei einer Plasmaleistungsdichte von 2,5 W.cm$^{-2}$ auf der Substratfläche und einer DC-self-bias-Spannung von -900 V wird eine a-C:H-Schicht mit einem optischen Bandabstand von 0,9 eV und einem spezifischen elektrischen Widerstand von $5.10^7\,\Omega.cm$ erhalten. Bei I-U-Messungen an der erhaltenen a-C:H/GaAs-Heterostruktur ergibt sich ein ausgeprägtes Diodenverhalten mit einer Sperrspannung um 1,5 V und einem Leckstrom < 1 mA.cm$^{-2}$.

**Patentansprüche**

1.  MISFET mit einer zwischen einer Gateelektrode und einem Halbleitersubstrat angeordneten Isolationsschicht, **dadurch gekennzeichnet,** daß die Isolationsschicht eine Schicht aus amorphem wasserstoffhaltigem Kohlenstoff (a-C:H) mit einer Dicke - im Bereich der Gateelektrode - bis zu 1 $\mu$m ist, die an der Grenzfläche zum Halbleitersubstrat einen spezifischen elektrischen Widerstand $\geq 10^6$ Ω.cm besitzt, und daß das Halbleitersubstrat aus einem Halbleitermaterial außer Silicium besteht.

2.  MISFET nach Anspruch 1, **dadurch gekennzeichnet,** daß der spezifische elektrische Widerstand der Grenzfläche $\leq 10^9$ Ω.cm beträgt.

3.  MISFET nach Anspruch 1 oder 2, **dadurch gekennzeichnet,** daß die Grenzfläche eine Dicke bis zu 50 nm aufweist.

4.  MISFET nach einem der Ansprüche 1 bis 3, **dadurch gekennzeichnet,** daß das Halbleitersubstrat aus monokristallinem Material besteht.

5.  MISFET nach einem oder mehreren der Ansprüche 1 bis 4, **dadurch gekennzeichnet,** daß das Halbleitersubstrat aus Ge, AlP, GaAs, GaP, GaSb, InAs, InP oder InSb besteht.

6.  MISFET nach einem oder mehreren der Ansprüche 1 bis 5, **dadurch gekennzeichnet,** daß das Halbleitersubstrat im Bereich außerhalb von Source und Drain jeweils durch eine a-C:H-Schicht abgedeckt ist.

7.  MISFET nach einem oder mehreren der Ansprüche 1 bis 6, **dadurch gekennzeichnet,** daß die a-C:H-Schicht durch eine Hochfrequenz-Niederdruck-Plasmaabscheidung gasförmiger Kohlenwasserstoffe hergestellt ist.

**Europäisches Patentamt**

# EUROPÄISCHER RECHERCHENBERICHT

Nummer der Anmeldung

## EP 91 11 3279

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | SOLID-STATE ELECTRONICS Band 29, Nr. 9, September 1986, Seiten 933-940, Exeter, Devon, GB; J.E. OH et al.: "InP MIS structures with diamondlike amorphous carbon films deposited by ion-beam sputtering and from plasma" * Zusammenfassung; Seite 934, Spalte 2, Absatz 1; Seite 935, Spalte 1, Absatz 1 * – – – | 1,3-7 | H 01 L 21/314 H 01 L 29/40 |
| X | THIN SOLID FILMS Band 157, Nr. 1, 15. Februar 1988, Seiten 97-103, Lausanne, Schweiz; J.J. POUCH et al.: "Plasma deposition of amorphous hydrogenated carbon films on III-V semiconductors" * Zusammenfassung; Seite 102, Absatz 3 * – – – | 1,3-5,7 | |
| X | EXTENDED ABSTRACTS Nr. 2, Oktober 1985, Seite 294, Pennington, NJ, US; J.J. POUCH et al.: "Carbon films grown from pla sma on III-V semiconductors" * Seite 294, Absatz 2 * – – – | 1,4,5,7 | |
| X | JOURNAL OF VACUUM SCIENCE & TECHNOLOGY/A Band 4, Nr. 3, Teil 1, Mai-Juni 1986, Seiten 1013-1017, Woodbury, NY, US; V.J. KAPOOR: "Diamondlike carbon films on semiconductors for insulated-gate technology" * Seite 1014, Spalte 1, Abschnitt III, Absatz 1 * – – – – – | 1,2 | RECHERCHIERTE SACHGEBIETE (Int. Cl.5) H 01 L |

Der vorliegende Recherchenbericht wurde für alle Patentansprüche erstellt

| Recherchenort | Abschlußdatum der Recherche | Prüfer |
|---|---|---|
| Berlin | 18 September 91 | JUHL A. |